Europäisches Patentamt

(19) European Patent Office

Office européen des brevets

(11) Numéro de publication: **0 234 968**
**B1**

(12) **FASCICULE DE BREVET EUROPEEN**

(45) Date de publication du fascicule du brevet:
**07.11.90**

(21) Numéro de dépôt: **87400063.1**

(22) Date de dépôt: **13.01.87**

(51) Int. Cl.⁵: **H03F 3/08, H04N 3/14**

(54) Procédé de lecture d'élément photosensible constitué d'une photodiode et d'une capacité.

(30) Priorité: **17.01.86 FR 8600656**

(43) Date de publication de la demande:
**02.09.87 Bulletin 87/36**

(45) Mention de la délivrance du brevet:
**07.11.90 Bulletin 90/45**

(84) Etats contractants désignés:
**DE GB NL**

(56) Documents cités:
**EP-A- 0 046 396**

**IEEE TRANSACTIONS ON NUCLEAR SCIENCE,
vol. 19, no. 3, juin 1972, pages 418-422, IEEE New York,
US; R. KURZ: "Low-noise preamplifier for high count
rates"
IBM TECHNICAL DISCLOSURE BULLETIN,
vol. 17, no. 11, avril 1975, pages 3321-3322, New York,
US; B.B. BAKER: "Photodiode array noise
compensation circuit"**

(73) Titulaire: **THOMSON-CSF, 51, Esplanade du Général de
Gaulle, F-92800 Puteaux(FR)**

(72) Inventeur: **Berger, Jean-Luc, THOMSON-CSF
SCPI 19, avenue de Messine, F-75008 Paris(FR)**
Inventeur: **Arques, Marc, THOMSON-CSF
SCPI 19, avenue de Messine, F-75008 Paris(FR)**

(74) Mandataire: **Turlèque, Clotilde et al, THOMSON-CSF
SCPI, F-92045 PARIS LA DEFENSE CEDEX 67(FR)**

## Description

L'invention se rapporte au domaine de la lecture de points photosensibles comportant principalement une photodiode.

La lecture de points photosensibles comportant une photodiode est généralement obtenue dans l'art connu au moyen d'éléments de commutation qui commandent la lecture.

Pour simplifier les procédés de fabrication, il est possible de s'orienter vers des structures d'éléments photosensibles qui ne comportent pas d'élément de commutation. Dans ce cas, on utilise pour la lecture un signal sous forme d'impulsions pour commander la décharge d'une capacité associée à la photodiode. Ce type de structure permet de réaliser des matrices de grandes dimensions, du fait que les dépôts en couche mince, de silicium amorphe par exemple, sont maintenant bien maîtrisés.

Pour la lecture de signaux analogiques de faible amplitude, par des matrices de ce type la charge stockée dans les éléments photosensibles n'est pas lue complètement si le courant de conduction a une valeur trop faible pour permettre l'évacuation de l'ensemble des charges.

L'invention a pour objet un procédé de lecture d'élément photosensible à diode photosensible et capacité, sans élément de commutation, qui permet la lecture de signaux analogiques, même de faible amplitude.

Selon l'invention un procédé de lecture d'élément photosensible à photodiode et capacité dans lequel la photodiode est polarisée en inverse pendant l'exposition au rayonnement utile et rendue passante au moyen d'impulsions périodiques pendant des intervalles de lecture, est caractérisé en ce que, après chaque impulsion de lecture, un fond de charge constant de polarisation est appliqué à la photodiode, afin de polariser la photodiode en direct au delà de sa tension de coude par les impulsions de lecture quel que soit le signal utile et assurer un courant de conduction suffisant pour que toute la charge utile soit lue, même lorsque le signal utile est de faible niveau, ce fond de charge étant obtenu en ramenant la tension aux bornes de la photodiode à une valeur prédéfinie, avant chaque exposition au rayonnement utile.

L'invention sera mieux comprise et d'autres caractéristiques apparaîtront à l'aide de la description qui suit en référence aux figures annexées.

La figure 1 représente les moyens de lecture d'un élément photosensible à photodiode et capacité ;

Les figures 2a, 2b, 2c, 2d, 2e et 2f sont des diagrammes de signaux explicatifs d'un procédé de lecture sans le perfectionnement selon l'invention ;

La figure 3 représente la caractéristique de la diode, c'est-à-dire son courant en fonction de la tension à ses bornes ;

La figure 4 est un diagramme de signaux illustrant la variation de l'efficacité de lecture ;

Les figures 5a, 5b, 5d, 5e, 5f et 5g sont des diagrammes de signaux explicatifs du procédé de lecture selon l'invention, suivant une première variante ;

Les figures 6a, 6b, 6d, 6e, 6f et 6g sont des diagrammes de signaux explicatifs du procédé de lecture selon l'invention, suivant une deuxième variante ;

Les figures 7a, 7b, 7d, 7e et 7f sont des diagrammes de signaux explicatifs du procédé de lecture selon l'invention, suivant une troisième variante.

Il a été indiqué ci-dessus qu'une phase du procédé de lecture suivant l'invention consiste à superposer au signal utile un fond de charge, pour polariser la diode en direct au delà de sa tension de coude de manière certaine lors de l'impulsion de commande de lecture même en l'absence de signal utile.

Trois variantes du procédé conduisent à une telle superposition :
- l'introduction dans le cycle de lecture d'une impulsion de remise à niveau qui polarise la diode au delà de son seuil de conduction en inverse suivie d'une phase de lecture "à blanc" ;
- un éclairement uniforme, d'intensité et de durée prédéterminées, qui superpose un fond de charge calibré $Q_0$ aux charges correspondant au signal utile $Q_S$ ;
- ou un éclairement par un flash lumineux intense pour introduire un fond de charge, suivi d'une lecture "à blanc".

Ces trois variantes permettent dans tous les cas de ramener la tension aux bornes de la diode à une valeur prédéfinie.

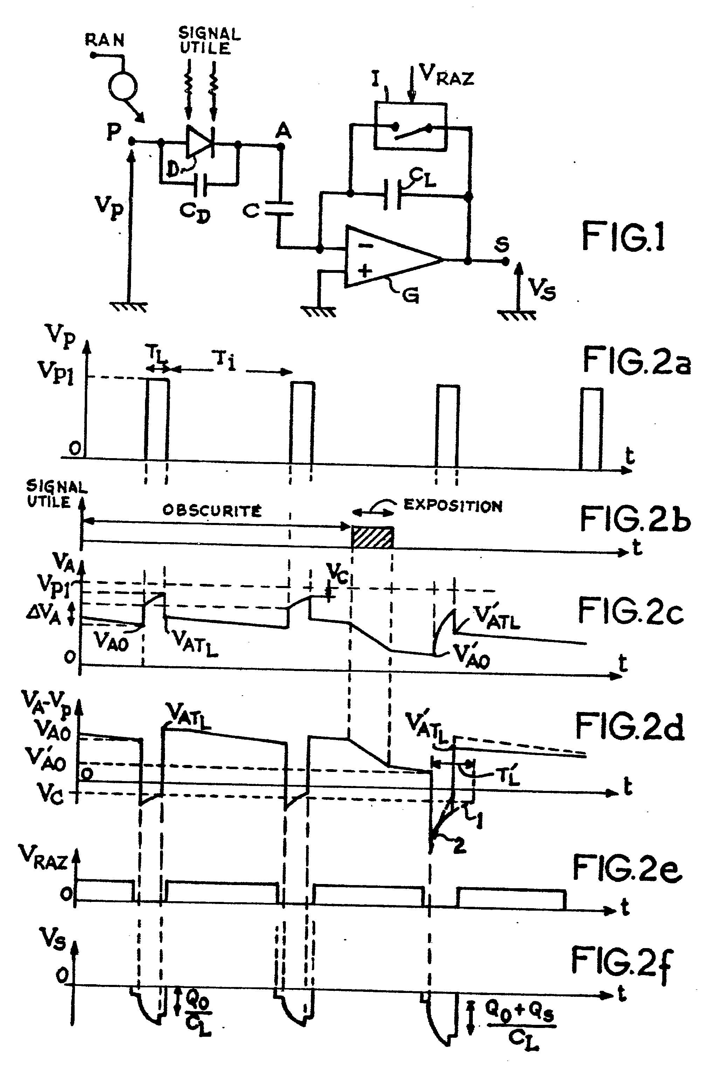

La description qui suit va permettre de mieux mettre en évidence le rôle de ces différents moyens de remise à niveau, en se référant tout d'abord, en liaison avec les figures 1 et 2a à 2f, à un procédé de lecture pulsée d'une photodiode à travers une capacité, sans le perfectionnement selon l'invention.

La figure 1 représente les moyens de lecture d'une photodiode D branchée entre deux points P et A, représentée avec sa capacité $C_D$ en parallèle. Cette diode D est placée en série avec une capacité C très supérieure à $C_D$ (au moins dix fois supérieure). L'autre armature de C est maintenue à la masse grâce à un amplificateur différentiel G monté en intégrateur, son entrée "+" étant reliée à la masse et sa sortie étant reliée à son entrée "-" par une capacité de lecture $C_L$. Un interrupteur I commandé par des impulsions $V_{RAZ}$ permet de remettre l'intégrateur à zéro.

La description qui suit du procédé de lecture est donnée en référence aux figures 2a à 2f.

Une impulsion de lecture $V_p$, de niveau $V_{P1}$ et de durée $T_L$, figure 2a, appliquée à la diode D au point P permet de charger la capacité C et amène la tension au point A à une valeur proche de l'amplitude $V_{P1}$ de l'impulsion appliquée. Lors du flanc descendant de cette impulsion, la capacité C conserve sa charge et la diode D se trouve donc polarisée en inverse. Cette polarisation est maintenue pendant une durée $T_i$ durant laquelle la tension au point P, $V_p$, est au niveau bas. Durant cette période la photodiode D peut recevoir des photons et décharger en conséquence la capacité C. La figure 2b représente le flash lumineux de signal utile ; la figure 2c représente l'évolution de la tension au point A, $V_A$ ; $V_{A0}$ et $V'_{A0}$ sont des valeurs de $V_A$ au début des impulsions de lecture et $V_{ATL}$ et $V'_{ATL}$ sont des va-

leurs de $V_A$ à la fin des impulsions de lecture. La variation de $V_A$, $\Delta V_A$ sur les flancs des impulsions de lecture correspond à

$$V_{P1} \cdot \frac{C_D}{C_D + C} \cdot V_A - V_{p'}$$

représenté sur la figure 2d est la tension aux bornes de la diode ; $V_{RAZ}$ représenté sur la figure 2e est la commande de remise à zéro de l'intégrateur I ; et $V_s$ représenté sur la figure 2f est la tension de sortie de cet intégrateur.

Lors du passage suivant de $V_p$ au niveau haut, $V_{P1}$ la capacité C est rechargée à sa charge initiale et le courant correspondant est intégré par la capacité de lecture $C_L$ de l'intégrateur. Ce dernier délivre alors une tension de signal $\Delta V_s$ correspondant à la quantité de charges nécessaire pour restaurer la charge initiale :

$$\Delta V_s = \frac{I_{PH} \cdot T_i}{C_L}$$

où $I_{PH}$ est le courant photonique de la diode pendant l'intervalle $T_i$. L'intégrateur est périodiquement remis à zéro par une impulsion $V_{RAZ}$ commandant la fermeture de l'interrupteur court circuitant $C_L$, de largeur légèrement supérieure à celle des impulsions de commande au point P et encadrant celles-ci.

Le potentiel du point A commun à la diode et à la capacité évolue au cours du temps selon la charge et la décharge de la capacité C. La tension au point A, $V_A$, est pendant $T_L$ amenée à une valeur proche du niveau haut de $V_p$, et $(V_p - V_A)_{TL}$ à la fin de l'impulsion de lecture est égale à $V_C$, $V_C$ étant la tension de coude de la diode, dont la valeur dépend à la fois du temps de lecture $T_L$, de la capacité C et du courant de saturation. Pour que la lecture soit efficace, il est nécessaire que la tension finale au point A, à la fin de l'impulsion de lecture, avant le flanc descendant de $V_p$, $V_{ATL}$ ne dépende pas des valeurs de tension initiale $V_{A0}$ lors de l'application du flanc montant de l'impulsion au point P. A cette condition la charge créée par le signal utile se trouve intégralement transmise à la capacité de lecture $C_L$. Sinon, comme indiqué ci-dessus la lecture est incomplète, la tension aux bornes de la diode n'étant pas ramenée à la tension de coude $V_C$ de la diode.

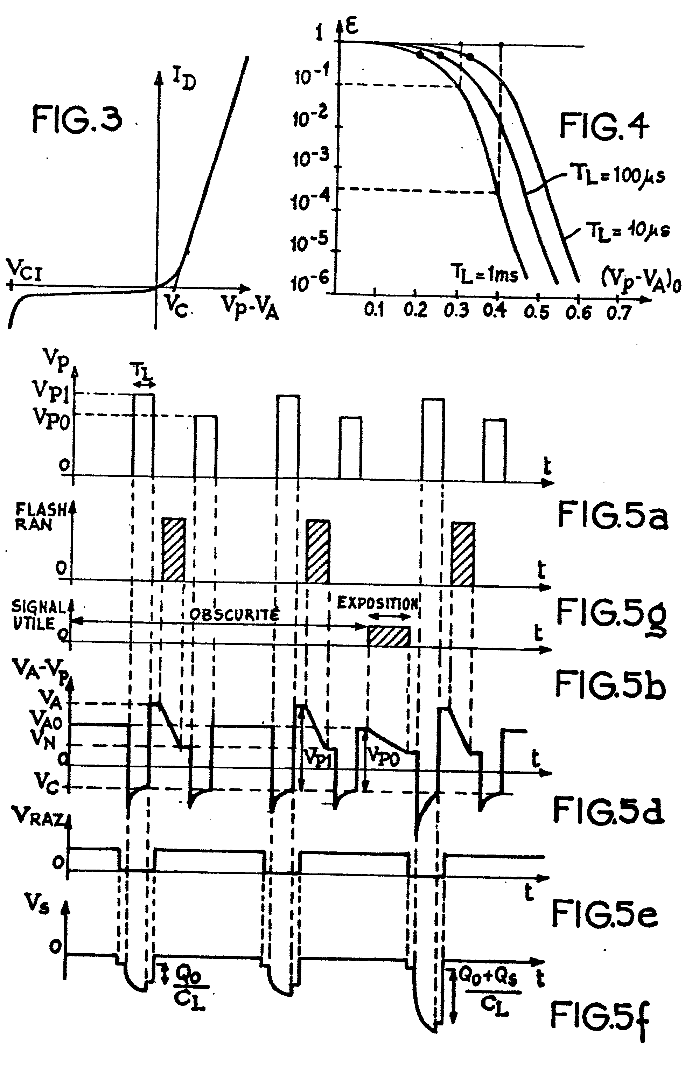

La figure 3 montre la caractéristique de la diode, c'est-à-dire son courant $I_D$ en fonction de la tension appliquée à ses bornes, avec sa tension de coude, $V_C$ et sa tension de coude inverse $V_{CI}$.

La charge de la capacité est fonction du courant $I_D$ variable avec la tension de départ $V_p - V_A$ au moment de l'application de l'impulsion au point P. L'évaluation de la charge finale de C à la fin de la durée de lecture $T_L$ montre qu'elle est fonction de la durée de l'impulsion de lecture $T_L$ et de la tension initiale à ses bornes.

Si la photodiode est maintenue dans l'obscurité comme montré sur la figure 2b pendant les deux premiers cycles d'intégration de durée Ti, la capacité C se trouve périodiquement rechargée de $V_{A0}$ à $V_{ATL}$ tant que le courant n'est pas modifié.

Lorsqu'une impulsion lumineuse, représentée sur la figure 2b est appliquée, la tension au point A, $V_A$ diminue du fait que le courant photonique moyen devient durant cette impulsion plus élevé, et la tension de départ au début de l'impulsion de lecture suivante $V'_{A0}$ est plus basse que $V_{A0}$. La tension finale à la fin de la période de lecture $V'_{ATTL}$ est différente de celle qui était obtenue en l'absence de signal lumineux. Une certaine fraction de la charge de la capacité n'est pas lue, ce qui entraîne une "inefficacité" de lecture ε:

$$\varepsilon = \frac{V'_{AT_L} - V_{AT_L}}{V'_{A0} - V_{A0}},$$

qu'il est possible d'évaluer en fonction des caractéristiques de la diode, de la valeur de la capacité C et de la durée de lecture $T_L$. L'expérience montre et le calcul confirme que si à courant constant le temps de lecture est très court pour un signal donné, l'efficacité de lecture est très faible, et si au contraire le temps de lecture augmente, l'efficacité de lecture augmente jusqu'à ce qu'au maximum, la valeur de la tension finale $V_{ATTL}$ sur la capacité C soit indépendante de la tension initiale $V_{A0}$ au moment de l'impulsion de lecture. Si la tension augmente, le courant moyen est plus grand et le temps de lecture peut être raccourci pour assurer une lecture convenable. Sur la figure 2d, on a représenté en trait plein une lecture incomplète pendant la 3e impulsion de lecture, et en pointillés deux lectures complètes, l'une (1) effectuée dans une durée $T'_L$ plus grande, l'autre (2) avec une tension et donc un courant plus élevé.

En d'autres termes, pour un temps de lecture donné, il existe une tension critique, égale à la tension coude de la diode D,

$$V_C = \frac{k \cdot T}{q} \, \text{Log} \, \frac{kT}{q} \, \frac{C}{I_0 \cdot T_L}$$

où k est la constante de Boltzmann, T est la température absolue, q est la charge de l'électron, et $I_0$ est le courant de saturation de la diode. L'impulsion de lecture doit déborder assez largement $V_C$ pour obtenir une bonne efficacité de lecture. Dans ce cas la tension au point A à la fin de l'impulsion de lecture est l'amplitude de cette impulsion diminuée de la tension coude. La tension initiale aux bornes de la diode, avant l'application de l'impulsion de lecture doit donc avoir une valeur telle que l'éclairement maximum seul n'amène pas la diode dans sa zone de conduction, et que, simultanément, l'impulsion de lecture même en l'absence d'éclairement amène de manière certaine la diode dans sa zone de conduction.

D'où la nécessité de superposer au signal un "fond de charge" $Q_0$ pour obtenir une efficacité de lecture convenable en présence de petits signaux. Ce fond de charge ou charge de polarisation peut être introduit soit au moyen d'une tension de décalage pour la remise à niveau, soit au moyen d'un éclairage qui conduit également la remise à niveau.

Les figures 5a, 5b, 5d, 5e, 5f et 5g représentent une première variante de remise à niveau. Les lettres références des figures correspondent à celles données aux figures 2a et suivantes, la figure 5g étant une figure supplémentaire représentant des impulsions lumineuses de remise à niveau, FLASH RAN. Sur ces figures et sur les suivantes, la tension $V_A$ n'a pas été représentée, et la variation $\Delta V_A$ a été négligée, $C_D$ étant très inférieur à C. Après une lecture de la charge de polarisation, la tension aux bornes de la diode se trouve augmentée de la quantité de charges qui a été lue :

$$V_A = V_{A0} + \frac{Q_0}{C} \ .$$

La diode se trouve donc polarisée plus fortement en inverse qu'avant la lecture. Le rôle de l'impulsion lumineuse de remise à niveau est de restituer le niveau de potentiel initial $V_{A0}$ aux bornes de la diode. Dans cette première variante l'impulsion lumineuse est intense ; elle décharge la diode jusqu'à un potentiel quelconque $V_N$, pourvu qu'il soit notablement inférieur à $V_{A0}$. On effectue ensuite une lecture à blanc à l'aide d'une impulsion $V_P$ d'amplitude $V_{P0}$ plus petite que $V_{P1}$. Pendant cette pseudo lecture, l'amplificateur intégrateur reste courtcircuité grâce à $V_{RAZ}$ et ne délivre pas de signal. L'amplitude $V_{P0}$ restaure, après lecture, la valeur initiale de tension aux bornes de la diode $V_{A0} = V_{P0} + V_C$ ($V_C$ négatif). La différence d'amplitude entre $V_{P1}$ et $V_{P0}$ définit la charge de polarisation $Q_0 = C(V_{P1} - V_{P0})$. Ainsi entre les séquences d'exposition et de lecture se trouve insérée une séquence de remise à niveau qui restaure la charge de polarisation $Q_0$.

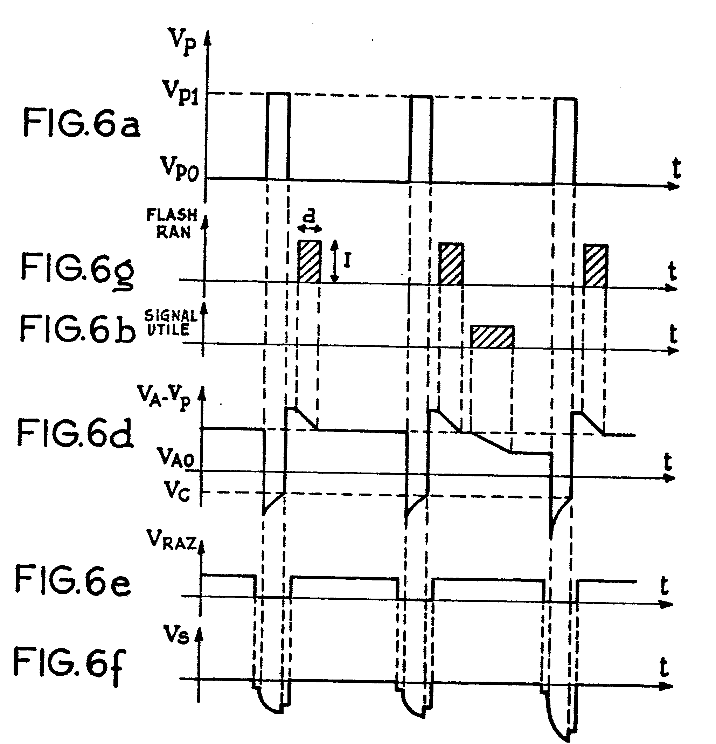

Les figures 6a, 6b, 6d, 6e et 6f représentent les mêmes signaux que sur la figure 5, avec une remise à niveau au moyen d'un éclairement uniforme calibré en durée d et intensité I. Les figures correspondantes portent les mêmes lettres que sur les figures 5a et suivantes. Chaque flash lumineux de remise à niveau, FLASH RAN, ramène la tension aux bornes de la diode toujours à la même valeur $V_{A0}$, tant lorsque l'élément photosensible n'a pas été éclairé que lorsqu'il a été soumis à un éclairement utile.

Dans cette variante il est inutile d'effectuer une lecture "à blanc" et il n'y a plus d'impulsions de lecture "à blanc" d'amplitude $V_{P0}$. La charge de polarisation $Q_0$ est restaurée à la fin de l'impulsion lumineuse calibrée de remise à niveau.

Une "remise à niveau" par un flash lumineux, dont la durée est de l'ordre de 1 ms, avant chaque lecture est la méthode préférée, en particulier lorsque les éléments photosensibles sont des points élémentaires isolés, car il n'y a pas de problème d'uniformité pour le rayonnement et il suffit que la tension de coude $V_C$ soit dépassée et que l'on y revienne de manière certaine.

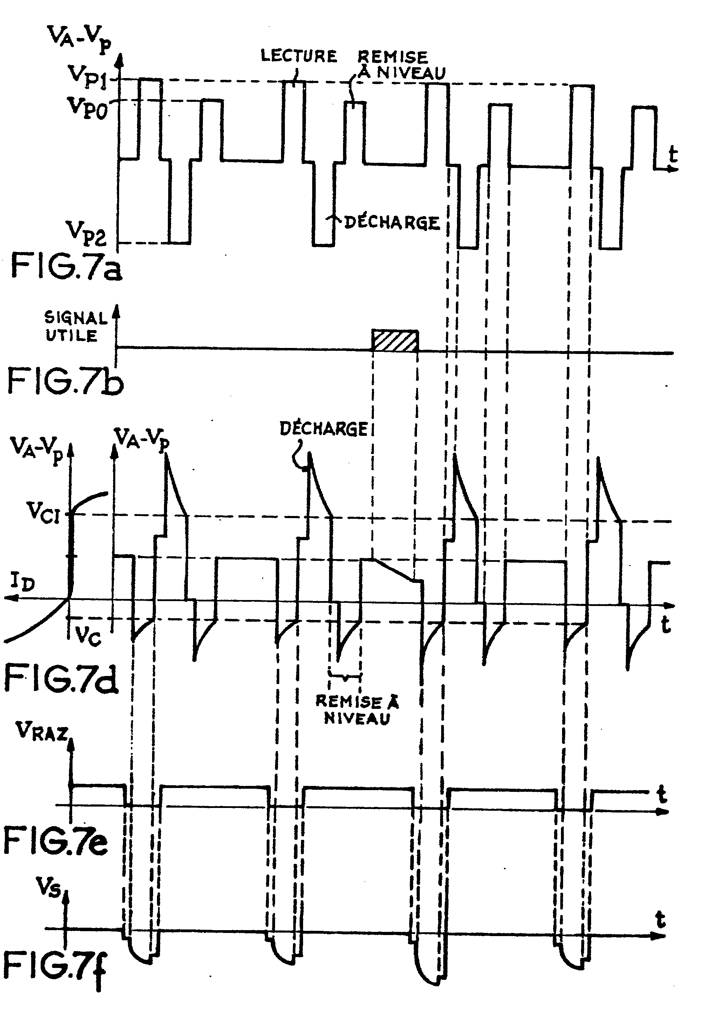

La "remise à niveau" représentée sur les figures 7a, 7b, 7d, 7e, 7f par une impulsion de polarisation avant chaque lecture, utilisant le coude inverse de la diode est un peu plus délicate dans sa mise en oeuvre, car il faut que les points d'avalanche des diodes, lorsqu'elles sont arrangées en matrice, ne soient pas trop dispersés, afin que les signaux de commande appliqués aux éléments photosensibles soient convenables pour tous les éléments. Une dispersion dans une plage de 8 à 10 V de la tension d'avalanche n'est pas tolérable. Si par contre, cette plage n'est que de l'ordre de 1 V pour l'ensemble des diodes de la matrice, alors la méthode de la remise à niveau par impulsions de polarisation est utilisable. Cette méthode consiste à appliquer au point P une impulsion négative d'amplitude $V_{P2}$ qui va décharger le condensateur C, la tension aux bornes de la diode étant portée par cette impulsion au delà de sa tension de coude inverse $V_{CI}$. La décharge ramène la tension à cette tension de coude inverse $V_{CI}$, et une impulsion de lecture à blanc calibrée, d'amplitude $V_{P0}$ polarise la diode en direct, ce qui ramène la tension à $V_C$, puis à $V_{A0}$ par le flanc descendant de cette impulsion de lecture.

La figure 4 représente "l'inefficacité" de lecture ε en fonction de la tension initiale en direct aux bornes d'une diode donnée, $(V_P - V_A)_0$, pour différentes durées d'impulsion de lecture $T_L = 1$ ms, $T_L = 100\mu s$, et $T_L = 10\mu s$. Ce diagramme montre à titre d'exemple qu'il est nécessaire de dépasser la tension de coude (notée par un point sur chacune des courbes) de 100 mV pour limiter l'inefficacité de lecture à l'ordre du pourcent et de la dépasser de 200 mV pour limiter l'inefficacité à 5/10000e environ.

De plus, il est connu que pour obtenir une lecture à faible bruit il est nécessaire de soustraire la tension de sortie avant arrivée du signal utile, à la tension de sortie après l'arrivée du signal utile. D'où la nécessité d'un "double échantillonnage", pour la lecture de la tension de sortie $V_S$ de l'intégrateur.

L'invention n'est pas limitée aux variantes du procédé précisément décrites et toutes variantes à la portée de l'homme de l'art, susceptibles d'aboutir à une telle remise à niveau sont du domaine de l'invention.

## Revendications

1. Procédé de lecture d'élément photosensible à photodiode (D) et capacité (C) dans lequel la photodiode est polarisée en inverse pendant l'exposition au signal utile et rendue passante au moyen d'impulsions périodiques pendant des intervalles de lecture, caractérisé en ce que, après chaque impulsion de lecture, un fond de charge constant de polarisation est appliqué à la photodiode, afin de polariser la photodiode en direct au delà de sa tension de coude par les impulsions de lecture quel que soit le signal utile et assurer un courant de conduction suffisant pour que toute la charge utile soit lue, même lorsque le signal utile est de faible niveau, ce fond de charge étant obtenu en ramenant la tension aux bornes de la photodiode à une valeur prédéfinie $V_{A0}$, avant chaque exposition au rayonnement utile.

2. Procédé selon la revendication 1, caractérisé en ce que le fond de charge superposé au signal utile est appliqué par un flash d'éclairement de remise à niveau transmis à la photodiode après chaque impulsion de lecture.

3. Procédé selon la revendication 2, caractérisé en ce que l'éclairement de remise à niveau est calibré en durée et en intensité, la tension aux bornes de la photodiode étant ramenée à la valeur constante prédéfinie $V_{A0}$ par ces flash de remise à niveau.

4. Procédé selon la revendication 2, caractérisé en ce que l'éclairement de remise à niveau est intense et suivi d'une phase de lecture à blanc au moyen d'une impulsion de lecture calibrée qui ramène le potentiel aux bornes de la photodiode à la valeur constante prédéfinie $V_{A0}$.

5. Procédé selon la revendication 1, caractérisé en ce que le fond de charge superposé au signal utile est obtenu
- par polarisation inverse forte de la photodiode pour dépasser la tension de coude inverse de cette photodiode et décharge de la capacité associée (C) jusqu'à cette valeur de tension de coude inverse,
- puis remise à niveau au moyen d'une impulsion de lecture calibrée.

## Patentansprüche

1. Verfahren zum Lesen eines lichtempfindlichen Elements bestehend aus einer Photodiode (D) und einem Kondensator (C), bei dem die Photodiode während der Belichtung durch das Nutzsignal umgekehrt vorgespannt ist und mit Hilfe von periodischen Impulsen während der Leseintervalle leitend gemacht wird, dadurch gekennzeichnet, daß nach jedem Leseimpuls eine konstante Grundpolarisationsladung an die Photodiode angelegt wird, um die Photodiode in Vorwärtsrichtung durch die Leseimpulse über ihre Knickspannung hinaus unabhängig vom Nutzsignal zu polarisieren und einen Leitungsstrom zu gewährleisten, der ausreicht, damit die gesamte Nutzladung gelesen wird, auch wenn das Nutzsignal niedrig ist, wobei die Grundladung vor jeder Belichtung mit dem Nutzsignal dadurch erhalten wird, daß die Spannung an den Klemmen der Diode auf einen vorbestimmten Wert $V_{A0}$ gebracht wird.

2. Verfahren nach Anspruch 1, dadurch gekennzeichnet, daß die dem Nutzsignal überlagerte Grundladung durch einen Pegeleinstellungs-Belichtungsblitz erzeugt wird, der nach jedem Leseimpuls und die Photodiode übertragen wird.

3. Verfahren nach Anspruch 2, dadurch gekennzeichnet, daß die Pegeleinstellungsbelichtung nach Dauer und Intensität kalibriert ist, wobei die Spannung an den Klemmen der Photodiode durch die Pegeleinstellungsblitze auf den vorbestimmten konstanten Wert $V_{A0}$ gebracht wird.

4. Verfahren nach Anspruch 2, dadurch gekennzeichnet, daß die Pegeleinstellungsbelichtung intensiv ist und daß ihr eine Weiß-Lesephase mit Hilfe eines kalibrierten Leseimpulses folgt, der das Potential an den Klemmen der Photodiode auf den vorbestimmten konstanten Wert $V_{A0}$ bringt.

5. Verfahren nach Anspruch 1, dadurch gekennzeichnet, daß die dem Nutzsignal überlagerte Grundladung erhalten wird durch
- starkes umgekehrtes Vorspannen der Photodiode zur Überwindung der inversen Knickpunktspannung der Photodiode, und durch ein Entladen des zugeordneten Kondensators (C) bis zu diesem Wert der inversen Knickpunktspannung,
- anschließende Pegeleinstellung mit Hilfe eines kalibrierten Leseimpulses.

## Claims

1. A method for reading a photosensitive element consisting of a photodiode (D) and a capacitor (C) in which the photodiode is inversely biassed during the exposure to the useful signal and made conductive by means of periodic pulses during the reading intervals, characterized in that after the occurence of each read pulse a constant base biassing charge is applied to the photodiode in order to bias the photodiode in forward direction beyond its kink voltage by the read pulses regardless of the useful signal and to ensure a conduction current large enough to get all of the charge read out, even when the useful signal is at low level, said base charge being obtained by bringing the voltage at the terminals of the photodiode to a predefined value $V_{A0}$ before each exposition to the useful radiation.

2. A method according to claim 1, characterized in that the charge superposed to the useful signal is applied through a level restoring flash transmitted to the photodiode after the occurence of each reading pulse.

3. A method according to claim 2, characterized in that the level restoring flash is calibrated as to the duration and intensity, the voltage at the terminals of the photodiode being brought to the predefined constant value $V_{A0}$ by the level restoring flashes.

5. A method according to claim 1, characterized in that the base charge superposed to the useful signal is obtained
- by strong inverse biassing of the photodiode in order to overcome the inverse kink voltage of said photodiode, and by discharge of the associated capacitor (C) down to said inverse kink voltage value,
- and followed by level restoration by means of a calibrated read pulse.

RAN

SIGNAL
UTILE

$V_{RAZ}$

I

P A

$V_P$

D

$C_D$

C

$C_L$

−

+

G

S

$V_S$

FIG.1

$V_P$

$V_{Pl}$

$T_L$ $T_i$

0 t

FIG.2a

SIGNAL
UTILE

OBSCURITÉ

EXPOSITION

t

FIG.2b

$V_A$

$V_{Pl}$

$V_C$

$\Delta V_A$

$V_{AO}$

$V_{ATL}$

$V'_{ATL}$

$V'_{AO}$

0 t

FIG.2c

$V_A - V_p$

$V_{AO}$

$V'_{AO}$

$V_C$

$V_{ATL}$

$V'_{ATL}$

$T'_L$

1

2

0 t

FIG.2d

$V_{RAZ}$

0 t

FIG.2e

$V_S$

0 t

$\dfrac{Q_0}{C_L}$

$\dfrac{Q_0 + Q_s}{C_L}$

FIG.2f

FIG.3

FIG.4

FIG.5a

FIG.5g

FIG.5b

FIG.5d

FIG.5e

FIG.5f

FIG.6a

$V_P$

$V_{p1}$

$V_{p0}$

t

FIG.6g

FLASH RAN

$a$

$I$

t

FIG.6b

SIGNAL UTILE

t

FIG.6d

$V_A-V_P$

$V_{A0}$

$V_C$

t

FIG.6e

$V_{RAZ}$

t

FIG.6f

$V_S$

t

EP 0 234 968 B1

FIG.7a

FIG.7b

FIG.7d

FIG.7e

FIG.7f